# EUROPEAN PATENT APPLICATION

(11) **EP 4 572 563 A1**
(43) Date of publication of application: **18.06.2025**
(21) Application number: 24211382.7
(22) Date of filing: 07.11.2024
(51) Int. Cl.: H10D 30/67

(54) **THIN FILM TRANSISTOR, MANUFACTURING METHOD THEREOF, AND DISPLAY APPARATUS COMPRISING THE SAME**

(30) Priority: 13.12.2023 KR 20230181025
(71) Applicant: LG Display Co., Ltd., Seoul 07336 (KR)
(72) Inventor: Park, Jaeyoon, 10845 Paju-si (KR); Jang, Jaeman, 10845 Paju-si (KR); Seul, Hyeonjoo, 10845 Paju-si (KR); Kang, Dongyeon, 10845 Paju-si (KR)
(74) Representative: Ter Meer Steinmeister & Partner

(57) **Abstract**

A thin film transistor, a display apparatus including the same, and a manufacturing method thereof is disclosed. The thin film transistor includes an active layer, a gate electrode spaced apart from the active layer and overlapping at least partially with the active layer. The active layer includes a channel area that overlaps the gate electrode in a plane, a source area connected to one side of the channel area in a plane, and a drain area connected to the other side of the channel area in a plane. The channel area includes a first channel area that overlaps the gate electrode. A second channel area is connected to the source area and doped by the first dopant element. A third channel area is connected to the drain area and doped by the first dopant element. The second channel area and the third channel area are spaced apart from each other.

## Description

### CROSS-REFERENCE TO RELATED APPLICATIONS

This application claims the benefit of priority of the Korean Patent Application No. 10-2023-0181025 filed on December 13, 2023.

### BACKGROUND

### Technical Field

The present disclosure relates to a thin film transistor, a method of manufacturing the same, and a display apparatus including the same.

### Description of the Related Art

Transistors are widely used as switching devices or driving devices in the field of electronic devices. In particular, since a thin film transistor may be manufactured on a glass substrate or a plastic substrate, it is widely used as a switching device of a display apparatus such as a liquid crystal display apparatus or an organic light emitting device.

Based on the material constituting the active layer, thin film transistors can be divided into amorphous silicon thin film transistors using amorphous silicon as the active layer, polycrystalline silicon thin film transistors using polycrystalline silicon as the active layer, and oxide semiconductor thin film transistors using oxide semiconductors as the active layer.

In an oxide semiconductor thin film transistor (TFT), since the oxide constituting the active layer can be formed at a relatively low temperature, has high mobility, and has a large resistance change according to the oxygen content, desired physical properties can be easily obtained. Also, due to the nature of the oxide, since the oxide semiconductor is transparent, it is also advantageous to implement a transparent display.

### BRIEF SUMMARY

In the oxide semiconductor of the related art, when the width of the active layer increases, the conductorization penetration depth (e.g. a conductorization depth in a direction parallel to the substrate) increases and the length of the effective channel decreases, thereby deteriorating the driving stability of the device. Therefore, the inventors of the present disclosure have appreciated this technical problem in the related art and suggested methods for controlling the conductorization penetration depth. Various embodiments of the present disclosure address the technical problems in the related art including the above-identified problem.

An object of the present disclosure is to provide a thin film transistor in which the active layer includes a channel area doped with a first dopant element, and the conductorization penetration depth is controlled even if the channel area has a large width.

An object of this disclosure is to provide a thin film transistor that prevents or suppresses the threshold voltage Vth from being shifted in a negative (-) direction even if the channel area has a large width, including a channel area doped by the first dopant element.

Another object of the present disclosure is to provide a display apparatus including such a thin film transistor.

Another object of the present disclosure is to provide a method of manufacturing such a thin film transistor.

In addition to the objects and technical benefits of the present disclosure as mentioned above, additional objects and benefits of the present disclosure will be clearly understood by those skilled in the art from the following description of the present disclosure.

At least one of these objects is solved by the subject-matter of the independent claim. Advantageous embodiments are defined by the respective dependent claims.

In accordance with an aspect of the present disclosure, a thin film transistor includes an active layer, a gate electrode spaced apart from the active layer and overlapping at least partially with the active layer, wherein the active layer includes a channel area that overlaps the gate electrode in a plane, a source area connected to one side of the channel area in a plane; and a drain area connected to the other side of the channel area in a plane, wherein the channel area includes a first channel area that overlaps the gate electrode; a second channel area connected to the source area and doped by the first dopant element; and a third channel area connected to the drain area and doped by the first dopant element, wherein the second channel area and the third channel area are spaced apart from each other.

According to a further aspect of the present disclosure, a thin film transistor includes: an active layer; and a gate electrode spaced apart from the active layer and overlapping at least partially with the active layer; wherein the active layer includes: a channel area that overlaps the gate electrode in a plane; a source area coupled to one side of the channel area in a plane; and a drain area coupled to the other side of the channel area in a plane; wherein the channel area includes: a first channel area that overlaps the gate electrode; a second channel area coupled to the source area and doped by a first dopant element; and a third channel area coupled to the drain area and doped by the first dopant element; wherein the second channel area and the third channel area are spaced apart from each other.

Another aspect of the present disclosure provides a display apparatus including at least one thin film transistor according to aspects and embodiments of the present disclosure. The display apparatus may include a display panel and/or at least one pixel. The display panel and/or the at least one pixel may include at least one thin film transistor according to aspects and embodiments of the present disclosure.

Another aspect of the present disclosure provides a manufacturing method of the thin film transistor, in particular the thin film transistor according to aspects and embodiments of the present disclosure, including forming an active layer and a gate insulating layer sequentially; first doping the active layer; forming a gate electrode that at least partially overlaps the active layer on the active layer; and second doping the active layer, the first doping the active layer includes forming a first gate electrode material layer on the active layer; and doping the active layer with a first dopant element using the first gate electrode material layer as a mask, the forming the gate electrode includes forming a second gate electrode material layer on the first gate electrode material layer; and etching the first gate electrode material layer and the second gate electrode material layer concurrently (or in some cases, simultaneously), the second doping the active layer includes doping the active layer with a second dopant element using the gate electrode as a mask, wherein the gate electrode includes a first gate electrode and a second gate electrode on the first gate electrode, and the first gate electrode material layer includes a hole exposing the gate insulating layer.

In the present disclosure "coupled to" or "connected to" may be interpreted such that two elements are disposed to be in direct contact with each other and/or are arranged adjacent to each other. "Overlapping in a plane" or "overlapping in a plane view" may be interpreted as overlapping in a direction perpendicular to a (main) surface of a base substrate.

Aspects and embodiments of the present disclosure may include one or several of the following optional features:

The second channel area and the third channel area are spaced apart from each other with the first channel area interposed there between and/or along the longitudinal direction (e.g. in a direction parallel to the substrate surface, e.g. a direction connecting source and drain region) of the channel area. The second channel area may be arranged between, in particular in direct contact with each of, the source area and the first channel area. The third channel area may be arranged between, in particular in direct contact with each of, the first channel area and the drain area.

The gate electrode may include a first gate electrode, in particular above or on the active layer and a second gate electrode on the first gate electrode. The first gate electrode and the second gate electrode may contact each other. At least a portion of the second gate electrode does not overlap the first gate electrode.

The first dopant element may include at least one of nitrogen (N), sulfur (S), chlorine (Cl), gallium (Ga), tungsten (W), iron (Fe), and tin (Sn).

The first channel area may overlap the first gate electrode and the second gate electrode. The second channel area and the third channel area may overlap the second gate electrode. The second channel area and the third channel area may not overlap the first gate electrode.

At least a portion of the second channel area and the third channel area may overlap the first gate electrode.

Each of the second channel area and the third channel area may include a first dopant element having a concentration of 4 to 15 atomic% based on the number of atoms.

The second channel area and the third channel area may have a carrier concentration lower than that of the first channel area.

The source area may include a first source area connected to the second channel area and doped by the first dopant element, and a second source area doped by the second dopant element. The drain area may include a first drain area connected to the third channel area and doped by the first dopant element, and a second drain area doped by the second dopant element. The second dopant element may include at least one of boron (B), phosphorus (P), fluorine (F), and hydrogen (H). The second channel area may be arranged between, in particular in direct contact with each of, the first source area and the first channel area. The third channel area may be arranged between, in particular in direct contact with each of, the first channel area and the first drain area.

The second channel area may include a plurality of second sub-channel areas. The third channel area may include a plurality of third sub-channel areas. Each of the plurality of second sub-channel areas may be spaced apart from each other. Each of the plurality of third sub-channel areas may be spaced apart from each other.

The first source area may include a plurality of first sub-source areas. The first drain area may include a plurality of first sub-drain areas Each of the plurality of first sub-source areas may be spaced apart from each other Each of the plurality of first sub-drain areas may be spaced apart from each other.

The thin film transistor may further include a source electrode and a drain electrode connected to the active layer. The source electrode may be connected to the source area. The drain electrode may be connected to the drain area.

The source electrode and the drain electrode may be disposed on the same layer and/or using the same material as the gate electrode.

The thin film transistor may further include a interlayer insulating layer disposed on the gate electrode. The source electrode and the drain electrode may be disposed on the interlayer insulating layer.

The source electrode may include a first source electrode and a second source electrode on the first source electrode. The drain electrode may include a first drain electrode and a second drain electrode on the first drain electrode. The first source electrode and the first drain electrode may be disposed on the same layer and/or using the same material as the first gate electrode. The second source electrode and the second drain electrode may be disposed on the same layer and/or using the same material as the second gate electrode.

At least a portion of the second gate electrode may cover a portion of a side surface of the first gate electrode. A portion of the second gate electrode may surround the first gate electrode.

A resistance of the second channel area and a resistance of the third channel area may be higher than resistance of the first channel area.

The resistance of the second channel area and the resistance of the third channel area may be higher than that of a region of the active layer other than the second channel area and the third channel area.

The hole may be surrounded by the first gate electrode material layer. The hole may include a plurality of sub-holes. Each of the plurality of sub-holes may be spaced apart from each other.

The second dopant element may include at least one of boron (B), phosphorus (P), fluorine (F), and hydrogen (H).

The first gate electrode may include a first side surface, a second side surface, and an upper surface between the first and second side surfaces. The second gate electrode may cover the first side surface, the second side surface, and the upper surface of the first gate electrode.

The second channel area and the third channel area may overlap with the second gate electrode and not the first gate electrode from a plan view.

### BRIEF DESCRIPTION OF THE SEVERAL VIEWS OF THE DRAWINGS

The above and other objects, features and other advantages of the present disclosure will be more clearly understood from the following detailed description taken in conjunction with the accompanying drawings, in which:
FIG. 1 is a plan view of a thin film transistor according to an embodiment of the present disclosure.
FIG. 2 is a cross-sectional view taken along line I-I' of FIG. 1.
FIG. 3 is a cross-sectional view taken along line II-II' of FIG. 1.
FIG. 4 is a cross-sectional view of a thin film transistor according to another embodiment of the present disclosure.
FIG. 5 is a diagram for describing a nitrogen (N) doping process, which is an example of the first dopant element of the present disclosure.
FIGS. 6A to 6E are process diagrams showing a process of manufacturing a thin film transistor according to an embodiment of the present disclosure.
FIG. 7 is a schematic view of a display device according to an embodiment of the present disclosure.
FIG. 8 is a circuit diagram of any one pixel of FIG. 7.
FIG. 9 is a plan view of the pixel of FIG. 8.
FIG. 10 is a cross-sectional view taken along line III-III' of FIG. 9.

### DETAILED DESCRIPTION

Advantages and features of the present disclosure and implementation methods thereof will be illustrated and clarified through the following embodiments described with reference to the accompanying drawings. The present disclosure may, however, be embodied in different forms and should not be construed as limited to the embodiments set forth herein.

A shape, a size, a dimension (e.g., length, width, height, thickness, radius, diameter, area, etc.), a ratio, an angle and a number disclosed in the drawings for describing embodiments of the present disclosure are merely an example and thus, the present disclosure is not limited to the illustrated details.

A dimension including size and a thickness of each component illustrated in the drawing are illustrated for convenience of description, and the present disclosure is not limited to the size and the thickness of the component illustrated, but it is to be noted that the relative dimensions including the relative size, location, and thickness of the components illustrated in various drawings submitted herewith are part of the present disclosure.

Like reference numerals refer to like elements throughout the specification. In the following description, when the detailed description of the relevant known function or configuration is determined to unnecessarily obscure the important point of the present disclosure, the detailed description will be omitted.

In a case where 'comprise', 'have' and 'include' described in the present disclosure are used, another portion may be added unless 'only~' is used. The terms of a singular form may include plural forms unless referred to the contrary.

In construing an element, the element is construed as including an error band although there is no explicit description.

In describing a position relationship, for example, when the position relationship is described as 'upon~', 'above~', 'below~' and `next to~', one or more portions may be disposed between two other portions unless `just' or 'direct' is used.

Spatially relative terms such as "below", "beneath", "lower", "above", and "upper" may be used herein to easily describe a relationship of one element or elements to another element or elements as illustrated in the drawings. It will be understood that these terms are intended to encompass different orientations of the device in addition to the orientation depicted in the drawings. For example, if the device illustrated in the figure is reversed, the device described to be arranged "below", or "beneath" another device may be arranged "above" another device. Therefore, an exemplary term "below or beneath" may include "below or beneath" and "above" orientations. Likewise, an exemplary term "above" or "on" may include "above" and "below or beneath" orientations.

In describing a temporal relationship, for example, when the temporal order is described as "after," "subsequent," "next," and "before," a case which is not continuous may be included, unless "just" or "direct" is used.

When it is mentioned that a first element "is connected or coupled to", "contacts or overlaps" etc. a second element, it should be interpreted that, not only can the first element "be directly connected or coupled to" or "directly contact or overlap" the second element, but a third element can also be "interposed" between the first and second elements, or the first and second elements can "be connected or coupled to", "contact or overlap", etc. each other via a fourth element. Here, the second element may be included in at least one of two or more elements that "are connected or coupled to", "contact or overlap", etc. each other.

It will be understood that, although the terms "first," "second," etc., may be used herein to describe various elements, these elements should not be limited by these terms. These terms are only used to distinguish one element from another. For example, a first element could be termed a second element, and, similarly, a second element could be termed a first element, without departing from the scope of the present disclosure.

It should be understood that the term "at least one" includes all combinations related with any one item. For example, "at least one among a first element, a second element and a third element" may include all combinations of two or more elements selected from the first, second and third elements as well as each element of the first, second and third elements.

Features of various embodiments of the present disclosure may be partially or overall coupled to or combined with each other and may be variously inter-operated with each other and driven technically as those skilled in the art can sufficiently understand. The embodiments of the present disclosure may be carried out independently from each other or may be carried out together in a co-dependent relationship.

In the addition of reference numerals to the components of each drawing describing embodiments of the present disclosure, the same components can have the same sign as can be displayed on the other drawings.

In the embodiments of the present disclosure, a source electrode and a drain electrode are distinguished for convenience of description, and the source electrode and the drain electrode may be interchanged. The source electrode may be the drain electrode and vice versa. In addition, the source electrode of any one embodiment may be a drain electrode in another embodiment, and the drain electrode of any one embodiment may be a source electrode in another embodiment.

In some embodiments of the present disclosure, for convenience of description, a source area is distinguished from a source electrode, and a drain area is distinguished from a drain electrode, but embodiments of the present disclosure are not limited thereto. The source area may be the source electrode, and the drain area may be the drain electrode. In addition, the source area may be the drain electrode, and the drain area may be the source electrode.

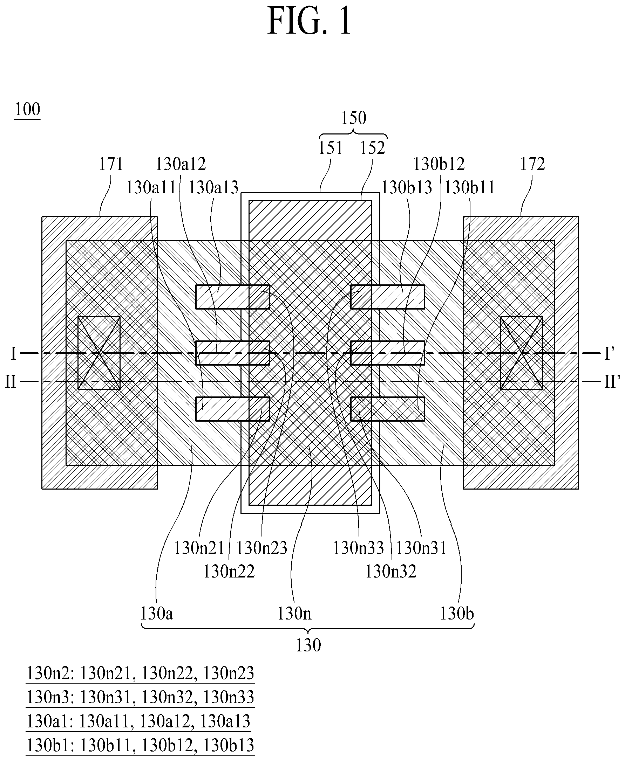

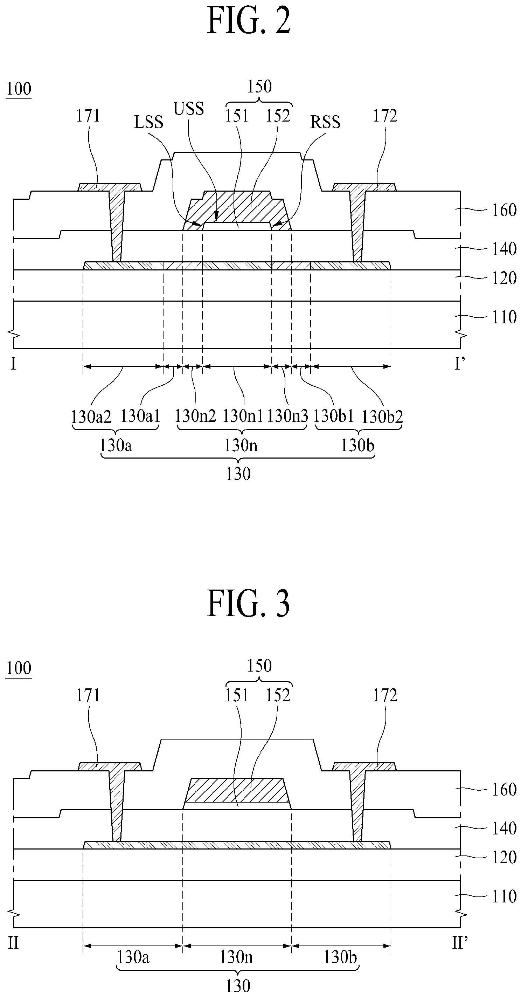

FIG. 1 is a plan view of a thin film transistor 100 according to an embodiment of the present disclosure. FIG. 2 is a cross-sectional view taken along line I-I' of FIG. 1. FIG. 3 is a cross-sectional view taken along line II- II' of FIG. 1.

Specifically, referring to FIGS. 1, 2, and 3, the thin film transistor 100 may include a buffer layer 120 on a base substrate 110, an active layer 130 on the buffer layer 120, and a gate electrode 150 spaced apart from the active layer 130 and overlapping at least partially with the active layer 130.

According to an embodiment of the present disclosure, the thin film transistor 100 may further include a base substrate 110. Referring to FIGS. 1, 2, and 3, the buffer layer 120 is disposed on the base substrate 110.

According to an embodiment of the present disclosure, the thin film transistor 100 may further include a gate insulating layer 140. Referring to FIGS. 1, 2, and 3, the gate insulating layer 140 may be disposed on the active layer 130. Specifically, the gate insulating layer 140 may be disposed between the active layer 130 and the gate electrode 150.

According to an embodiment of the present disclosure, another layer of the thin film transistor 100 may be additionally disposed on the gate electrode 150. The thin film transistor 100 may further include an interlayer insulating layer 160. Referring to FIG. 2, the interlayer insulating layer 160 is disposed on the gate electrode 150. The gate electrode 150 may be disposed between the gate insulating layer 140 and the interlayer insulating layer 160.

According to an embodiment of the present disclosure, the thin film transistor 100 may further include a source electrode 171 and a drain electrode 172. Referring to FIGS. 1, 2, and 3, the source electrode 171 and the drain electrode 172 may be disposed on the interlayer insulating layer 160.

Hereinafter, components of the thin film transistor 100 according to an embodiment of the present disclosure will be described in more detail.

Glass or plastic may be used for the base substrate 110. Transparent plastic having flexible characteristics, for example, polyimide, may be used as plastic.

When the polyimide is used as the base substrate 110, considering that a high-temperature deposition process is performed on the base substrate 110, a heat-resistant polyimide capable of withstanding a high temperature may be used. In this case, in order to form a thin film transistor, processes such as deposition, etching, and the like may be performed in a state in which the polyimide substrate is disposed on the carrier substrate made of a high-durable material such as glass.

Referring to FIGS. 1, 2, and 3, a buffer layer 120 may be disposed on the base substrate 110.

The buffer layer 120 is formed on the base substrate 110 and may be formed of an inorganic material or an organic material. For example, an insulating oxide such as silicon oxide (SiOx), aluminum oxide (Al2O3) and the like may be included.

The buffer layer 120 protects the active layer 130 by blocking impurities such as moisture and oxygen introduced from the base substrate 110, serves to flatten the upper portion of the base substrate 110, and may be formed as a single layer or a plurality of layers.

Referring to FIGS. 1, 2, and 3, an active layer 130 may be disposed on the buffer layer 120.

The active layer 130 may include a channel area 130n, a source area 130a, and a drain area 130b.

The channel area 130n overlaps the gate electrode 150, in particular in a direction perpendicular to a surface of the base substrate 110. The channel area 130n serves as and/or may constitute a channel of the thin film transistor 100.

Specifically, the active layer 130 may include a channel area 130n overlapping the gate electrode 150, in particular in a direction perpendicular to a surface of the base substrate 110, a source area 130a connected to one side of the channel area 130n without overlapping the gate electrode 150, in particular in a direction perpendicular to a surface of the base substrate 110, and a drain area 130b connected to the other side of the channel area 130n without overlapping the gate electrode 150, in particular in a direction perpendicular to a surface of the base substrate 110. Specifically, the active layer 130 may include a channel area 130n overlapping the gate electrode 150 in a plane, the source area 130a connected to one side of the channel area 130n without overlapping the gate electrode 150 in a plane, and the drain area 130b connected to the other side of the channel area 130n without overlapping the gate electrode 150 in a plane. The source area 130a may be arranged in direct contact with the channel area 130n, and the drain area may be arranged in direct contact with the channel area 130.

According to an embodiment of the present disclosure, the source area 130a and the drain area 130b are spaced apart from each other with the channel area 130n interposed therebetween.

According to an embodiment of the present disclosure, the active layer 130 may be formed of a semiconductor material. The active layer 130 may include an oxide semiconductor material.

The oxide semiconductor material may include at least one of an IZO (InZnO)-based oxide semiconductor material, an IGO (InGaO)-based oxide semiconductor material, an ITO (InSnO)-based oxide semiconductor material, an IGZO (InGaZnO)-based oxide semiconductor material, an IGZTO (InGaZnSnO)-based oxide semiconductor material, a GZTO (GaZnSnO)-based oxide semiconductor material, a GZO (GaZnO)-based oxide semiconductor material, an ITZO (InSnZnO)-based oxide semiconductor material, and a FIZO (FeInZnO)-based oxide semiconductor material. However, an embodiment of the present disclosure is not limited thereto, and the active layer 130 may be made of another oxide semiconductor material known in the art.

According to an embodiment of the present disclosure, the channel area 130n includes a first channel area 130n1, a second channel area 130n2, and a third channel area 130n3

Specifically, referring to FIGS. 1 and 2, the channel area 130n may include a first channel area 130n1 overlapping the gate electrode 150, in particular in a direction perpendicular to a surface of the base substrate 110, a second channel area 130n2 connected to the source area 130a, doped by the first dopant element, and a third channel area 130n3 connected to the drain area 130b doped by the first dopant element. The second channel area 130n2 and the third channel area 130n3 may not overlap a first gate electrode 151 of the gate electrode 150, in particular in a direction perpendicular to a surface of the base substrate 110.

The second channel area 130n2 and the third channel area 130n3 are spaced apart from each other with the first channel area 130n1 interposed therebetween and/or along the longitudinal direction of the channel area 130n. The second channel 130n2 area may be arranged between, in particular in direct contact with each of, the source area 130a and the first channel area 130n1. The third channel area 130n3 may be arranged between, in particular in direct contact with each of, the first channel area 130n1 and the drain area 130b.

In this case, the first dopant element may include at least one of nitrogen (N), sulfur (S), chlorine (Cl), gallium (Ga), tungsten (W), iron (Fe), and tin (Sn).

More specifically, referring to FIGS. 1 and 2, the second channel area 130n2 and the third channel area 130n3 are disposed to be spaced apart from each other with the first channel area 130n1 interposed therebetween. The second channel area 130n2 may be disposed to be directly adjacent to and/or directly in contact to the source area 130a. The third channel area 130n3 may be disposed to be directly adjacent to and/or directly in contact to the drain area 130b.

In general, when the channel area 130n of the active layer 130 has a large channel width W, conductorization diffusion may largely proceed or occur in the boundary regions between the channel area 130n, and the source area, and the drain area 130a and 130b, respectively. If conductorization diffusion proceeds or occurs, a threshold voltage Vth of the thin film transistor 100 may move in a negative (-) direction, and thus driving stability of the thin film transistor 100 may deteriorate. In this case, a channel width W of the channel area 130n may mean a direction perpendicular to a longitudinal direction of the channel area 130n, and a longitudinal direction of the channel area 130n means a direction parallel to a line connecting the source area 130a and the drain area 130b by the shortest distance.

When the channel area 130n of the active layer 130 has a small channel width W, conductorization diffusion may decrease in the boundary region between the channel area 130n, the source area, and the drain area 130a and 130b, respectively. Also, when the channel area 130n of the active layer 130 has a small channel width W, the total amount of carriers passing through the channel area 130n of the thin film transistor 100 may decrease, and on current characteristics may decrease. As a result, when a large amount of current flows through the thin film transistor 100 having a small channel width W of the channel area 130n, the thin film transistor 100 may be damaged, and thus driving stability may be deteriorated. Accordingly, it is necessary for the active layer 130 to control conductorization diffusion while having a large channel width W.

More specifically, in the active layer 130 made of an oxide semiconductor material, hydrogen (H) introduced from an insulating layer or the like is contained in a region of the channel area 130n adjacent to the source area 130a and the drain area 130b. More specifically, a high concentration of hydrogen (H) is included in a region adjacent to the source area 130a and the drain area 130b (e.g. a region within the channel region close to the source area and the drain area), and the high concentration of hydrogen is combined with an oxygen vacancy (Vo) position present in the adjacent active layer 130 to generate a carrier. In this case, the oxygen defect Vo is largest at an end of the active layer 130 in the longitudinal direction and smallest at a center portion thereof. Therefore, when the channel area 130n has a large channel width W, a penetration length of hydrogen penetrating from a region of the channel area 130n adjacent to the source area 130a and the drain area 130b, respectively, is lengthened. As a result, a threshold voltage (Vth) of the thin film transistor 100 moves in a negative (-) direction, and thus driving stability of the thin film transistor 100 may deteriorate.

In order to suppress and prevent such conductorization diffusion and change in threshold voltage, the second channel area 130n2 and the third channel area 130n3 may be doped by the first dopant element.

When the second channel area 130n2 and the third channel area 130n3 are doped by the first dopant element, the first dopant element included in the second channel area 130n2 and the third channel area 130n3 may be disposed at the position of the Oxygen Vacancy (Vo) present in the second channel area 130n2 and the third channel area 130n3 to fill the position of the Oxygen Vacancy (Vo) and may be stably disposed between metals. In addition, the first dopant element disposed at the position of the Oxygen Vacancy (Vo) increases in bonding with hydrogen (H), and thus hydrogen penetrating into the channel area 130n from the source area 130a and the drain area 130b may be suppressed and prevented. As a result, even if the channel area 130n has a large width (W), the depth of conductorization penetration may be controlled, and the threshold voltage (Vth) of the thin film transistor 100 may be suppressed and prevented from moving in the negative (-) direction.

Specifically, due to doping of the first dopant element, the resistance of the second channel area 130n2 and the third channel area 130n3 may be higher than that of the first channel area 130n1.

According to an embodiment of the present disclosure, each of the second channel area 130n2 and the third channel area 130n3 may include a first dopant element having a concentration of 4 to 15 atomic% based on the number of atoms. For example, each of the second channel area 130n2 and the third channel area 130n3 may include nitrogen (N) having a concentration of 4 to 15 atomic% based on the number of atoms.

When the second channel area 130n2 and the third channel area 130n3 include a first dopant element having a concentration of 4 to 15 atomic% based on the number of atoms, even if the channel area 130n has a large width W, the conductorization penetration depth may be controlled, and the threshold voltage (Vth) of the thin film transistor 100 may be suppressed and prevented from moving in the negative (-) direction.

On the other hand, when each of the second channel area 130n2 and the third channel area 130n3 includes a first dopant element having a concentration of less than 4 atomic% based on the number of atoms, the first dopant element is not sufficiently doped in the second channel area 130n2 and the third channel area 130n3, and thus, the unbonded hydrogen penetrates into the channel area 130n, thereby increasing the carrier concentration of a region of the channel area 130n adjacent to the source area 130a and the drain area 130b. As a result, the threshold voltage (Vth) of the thin film transistor 100 moves in the negative (-) direction, and thus the driving stability of the thin film transistor 100 may deteriorate.

In addition, if the second channel area 130n2 and the third channel area 130n3 each contain a first dopant element with a concentration greater than 15% based on the number of atoms, the content of oxygen contained in the active layer 130 becomes less than 50%, making it difficult to form oxides such as IGZO, and problems that do not have properties as semiconductors occur.

According to an embodiment of the present disclosure, when the second channel area 130n2 and the third channel area 130n3 are doped by the first dopant element, a low carrier concentration is provided. Specifically, the second channel area 130n2 and the third channel area 130n3 doped by the first dopant element have a lower carrier concentration than the first channel area 130n1 not doped by the first dopant element. In this case, when the thin film transistor according to the present disclosure is an N-type oxide thin film transistor, the carrier may be electrons, and when the thin film transistor is a P-type oxide thin film transistor, the carrier may be a hole.

The first dopant element may include at least one of nitrogen (N), sulfur (S), chlorine (Cl), gallium (Ga), tungsten (W), iron (Fe), and tin (Sn).

For example, when nitrogen (N), sulfur (S), and chlorine (Cl) are used as the first dopant element, nitrogen (N), sulfur (S), and chlorine (Cl) have the ability to capture hydrogen (H) by combining with metal atoms present in the active layer 130.

In addition, for example, if gallium (Ga), tungsten (W), iron (Fe), and tin (Sn) are used as the first dopant element, gallium (Ga), tungsten (W), iron (Fe), and tin (Sn) can suppress carriers (electrons) formed from defects in indium (In) and oxygen (O) present in the active layer 130.

According to an embodiment of the present disclosure, the source area 130a may include a first source area 130a1 and a second source area 130a2, and the drain area 130b may include a first drain area 130b1 and a second drain area 130b2.

Specifically, the source area 130a is connected to the second channel area 130n2, includes the first source area 130a1 doped by the first dopant element, and the second source area 130a2 doped by the second dopant element, and the drain area 130b is connected to the third channel area 130n3, and includes the first drain area 130b1 doped by the first dopant element and the second drain area 130b2 doped by the second dopant element. The first source area 130a1 may be disposed to be directly adjacent to and/or directly in contact to the second channel area 130n2. The first drain area 130b1 may be disposed to be directly adjacent to and/or directly in contact to the third channel area 130n3. The second channel area 130n2 may be arranged between, in particular in direct contact with each of, the first source area 130a1 and the first channel area 130n1. The third channel area 130n3 may be arranged between, in particular in direct contact with each of, the first channel area 130n1 and the first drain area 130b1.

In this case, the second dopant element for forming the second source area 130a2 and the second drain area 130b2 may include at least one of boron (B), phosphorus (P), fluorine (F), and hydrogen (H).

When each of the first source area 130a1 and the first drain area 130b1 is doped with the first dopant element, the first dopant element included in the first source area 130a1 and the first drain area 130b1 may be disposed at the position of an Oxygen Vacancy (Vo) present in the first source area 130a1 and the first drain area 130b1 to fill the position of an Oxygen Vacancy (Vo), and may be stably disposed between metals. Furthermore, the first dopant element disposed at the position of the Oxygen Vacancy (Vo) may suppress and prevent an increase in the concentration of carriers by ionizing hydrogen (H) in regions adjacent to the channel area 130n in the source area 130a and the drain area 130b due to an increase in bonding with hydrogen (H). As a result, even if the channel area 130n has a large width (W), the depth of conductorization penetration may be controlled, and a threshold voltage (threshold voltage: Vth) of the thin film transistor 100 may be suppressed and prevented from moving in a negative (-) direction.

In addition, the second source area 130a2 and the second drain area 130b2 may be formed by selective conductorization with respect to the active layer 130 made of a semiconductor material. According to an embodiment of the present disclosure, imparting conductivity to a specific portion of the active layer 130 so that it may function as a conductor is referred to as selective conductorization. By this selective conductorization, a portion where conductivity is imparted is conductorized, and a portion where conductivity is not imparted is not conductorized.

The second source area 130a2 and the second drain area 130b2 illustrated in FIGS. 1 and 2 are portions to which conductivity is imparted by selective conductorization.

According to an embodiment of the present disclosure, the second channel area 130n2 includes a plurality of second sub-channel areas 130n21, 130n22, and 130n23, and the third channel area 130n3 includes a plurality of third sub-channel areas 130n31, 130n32, and 130n33.

In FIG. 1, a second channel area 130n2 including a plurality of second sub channel areas 130n21, 130n22, and 130n23 is illustrated, and in this case, a plurality of second sub channel areas 130n21, 130n22, and 130n23 are disposed to be spaced apart from each other.

Also, in FIG. 1, a third channel area 130n3 including a plurality of third sub channel areas 130n31, 130n32, and 130n33 is illustrated, and in this case, a plurality of third sub channel areas 130n31, 130n32, and 130n33 are disposed to be spaced apart from each other. An embodiment of the present disclosure is not limited thereto, and a single second sub-channel area and a single third sub-channel area may be provided, respectively. Also, a number of second sub-channel areas and a number of third sub-channel areas may be four or more.

According to an embodiment of the present disclosure, the first source area 130a1 includes a plurality of first sub-source areas 130a11, 130a12, and 130a13, and the first drain area 130b1 includes a plurality of first sub-drain areas 130b1 1, 130b12, and 130b13.

In FIG. 1, a first source area 130a1 including a plurality of first sub-source areas 130a11, 130a12, and 130a13 is illustrated, and in this case, a plurality of first sub-source areas 130a11, 130a12, and 130a13 are disposed to be spaced apart from each other. The plurality of first sub-source areas 130a11, 130a12, and 130a13 may be disposed to be spaced apart from each other in a direction perpendicular to the longitudinal direction of the channel area 130n.

Also, a first drain area 130b1 including a plurality of first sub-drain areas 130b11, 130b12, and 130b13 is illustrated in FIG. 1, and in this case, a plurality of first sub-drain areas 130b11, 130b12, and 130b13 are disposed to be spaced apart from each other. An embodiment of the present disclosure is not limited thereto, and a single first sub-source area and a single first sub-drain area may be provided. Also, a number of first sub-source areas and a number of first sub-drain areas may be four or more.

A configuration in which the active layer 130 is formed of a single layer is disclosed in FIGS. 1, 2, and 3, but the present disclosure is not limited thereto. The active layer 130 may have a single layer structure or a multilayer structure.

The gate insulating layer 140 is disposed on the active layer 130. The gate insulating layer 140 protects the channel area 130n. Specifically, the gate insulating layer 140 is disposed between the active layer 130 and the gate electrode 150.

The gate insulating layer 140 has insulating properties. The gate insulating layer 140 may include at least one of silicon oxide, silicon nitride, and metal-based oxide, for example. The gate insulating layer 140 may have a single layer structure or a multilayer structure.

The gate electrode 150 is disposed on the gate insulating layer 140. The gate electrode 150 overlaps the channel area 130n of the active layer 130, in particular in a direction perpendicular to a surface of the base substrate 110.

The gate electrode 150 may include at least one among an aluminum-based metal such as aluminum (Al) or an aluminum alloy, a silver-based metal such as silver (Ag) or a silver alloy, a copper-based metal such as copper (Cu) or a copper alloy, a molybdenum-based metal such as molybdenum (Mo) or a molybdenum alloy, and chromium (Cr), tantalum (Ta), neodymium (Nd), and titanium (Ti). The gate electrode 150 may have a multilayer structure including at least two conductive layers each having different physical properties. For example, the gate electrode 150 may include at least one of molybdenum (Mo) and titanium (Ti).

According to an embodiment of the present disclosure, the gate electrode 150 includes a first gate electrode 151 on the active layer 130 and a second gate electrode 152 on the first gate electrode 151.

In FIGS. 1, 2, and 3, a configuration in which the first gate electrode 151 and the second gate electrode 152 are in contact with each other is illustrated.

Referring to FIGS. 1, 2, and 3, at least a part of the second gate electrode 152 may not overlap the first gate electrode 151 from a plan view and/or in a direction perpendicular to a surface of the base substrate 110.

Specifically, referring to FIGS. 1, 2, and 3, the first channel area 130n1 overlaps the first gate electrode 151 and the second gate electrode 152 at the same time, and the second channel area 130n2 and the third channel area 130n3 overlap the second gate electrode 152 without overlapping the first gate electrode 151 from a plan view and/or in a direction perpendicular to a surface of the base substrate 110. A boundary between the first channel area 130n1 and the second channel area 130n2, in particular in a direction perpendicular to the longitudinal direction of the channel area 130n, may be aligned, at least partially, with the boundary between first gate electrode 151 and the second gate electrode in a direction perpendicular to a surface of the base substrate 110. A boundary between the first channel area 130n1 and the third channel area 130n3, in particular in a direction perpendicular to the longitudinal direction of the channel area 130n, may be aligned, at least partially, with the boundary between first gate electrode 151 and the second gate electrode in a direction perpendicular to a surface of the base substrate 110.

A boundary between the second channel area 130n2 and the first source area 130a1, in particular in a direction perpendicular to the longitudinal direction of the channel area 130n, may be aligned, at least partially, with an outer boundary or edge of the second gate electrode 152 in a direction perpendicular to a surface of the base substrate 110. A boundary between the third channel area 130n3 and the first drain area 130b1, in particular in a direction perpendicular to the longitudinal direction of the channel area 130n, may be aligned, at least partially, with an outer boundary or edge of the second gate electrode 152.

More specifically, the second channel area 130n2 and the third channel area 130n3 are formed by doping the first dopant element using the first gate electrode 151 that does not overlap the second channel area 130n2 and the third channel area 130n3 as masks, in particular in a direction perpendicular to a surface of the base substrate 110.

However, an embodiment of the present disclosure is not limited thereto, and according to an embodiment of the present disclosure, at least a portion of the second channel area 130n2 and the third channel area 130n3 may overlap the first gate electrode 151, in particular in a direction perpendicular to a surface of the base substrate 110.

Specifically, the first dopant element doped into the second channel area 130n2 and the third channel area 130n3 may be diffused in the direction of the first channel area 130n1. Accordingly, at least a portion of the second channel area 130n2 and the third channel area 130n3 doped with the first dopant element may overlap the first gate electrode 151.

According to an embodiment of the present disclosure, the first source area 130a1 of the source area 130a and the first drain area 130b1 of the drain area 130b include the first dopant element, but the concentration of the first dopant element included in the first source area 130a1 of the source area 130a and the first drain area 130b1 of the drain area 130b may be lower than the concentration of the first dopant element included in the second channel area 130n2 and the third channel area 130n3.

Specifically, the first source area 130a1, the first drain area 130b1, the second channel area 130n2, and the third channel area 130n3 are all doped by the first dopant element using the first gate electrode 151 as a mask, but unlike the second channel area 130n2 and the third channel area 130n3, the first source area 130a1 and the first drain area 130b1 are also doped by the second dopant element using the second gate electrode 152 as a mask. As a result, the concentration of the first dopant element included in the first source area 130a1 of the source area 130a and the first drain area 130b1 of the drain area 130b may be lower than the concentration of the first dopant element included in the second channel area 130n2 and the third channel area 130n3.

More specifically, resistance of the second channel area 130n2 and the third channel area 130n3 may be higher than resistance of regions of the active layer 130 except for the second channel area 130n2 and the third channel area 130n3. In other words, resistance of the second channel area 130n2 and the third channel area 130n3 may be higher than resistance of each of the first channel area 130n1, the source area 130a, and the drain area 130b.

In some embodiments, the first source area 130a1 of the source area 130a includes an area that does not overlap with both the gate electrode 150 and the source electrode 171 from a plan view and/or in a direction perpendicular to a surface of the base substrate 110. Similarly, the first drain area 130b1 of the drain area 130b includes an area that does not overlap with both the gate electrode 150 and the drain electrode 172 from a plan view and/or in a direction perpendicular to a surface of the base substrate 110. Here, the first source area 130a1 of the source area 130a doped by the first dopant element and the first portion of the channel area (e.g., second channel area 130n2) doped by the first dopant element abut each other and are continuously and contiguously coupled to each other. Similarly, the first drain area 130b1 of the drain area 130b doped by the first dopant element and the second portion of the channel area (e.g., third channel area 130n3) doped by the first dopant element abut each other and are continuously and contiguously coupled to each other.

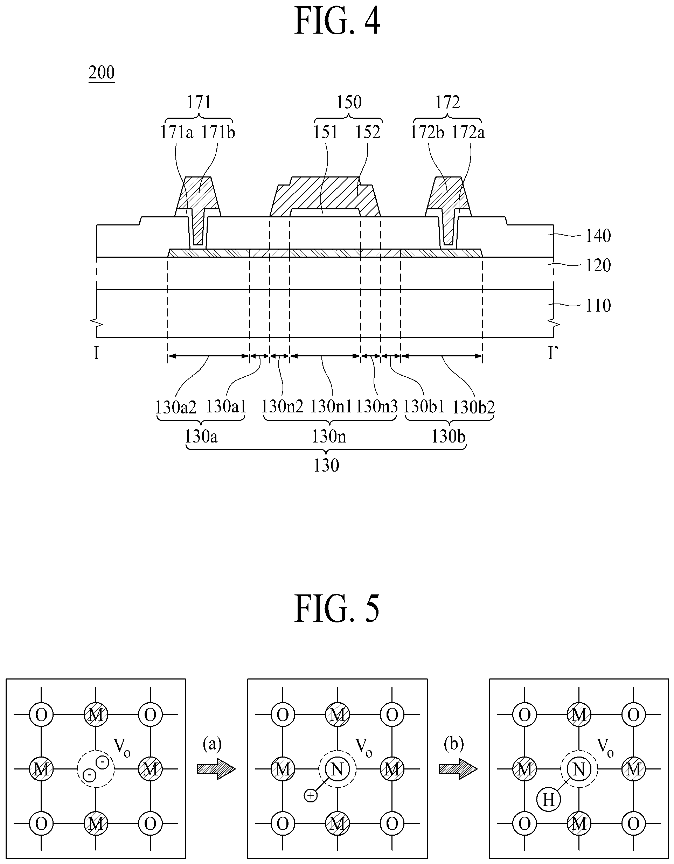

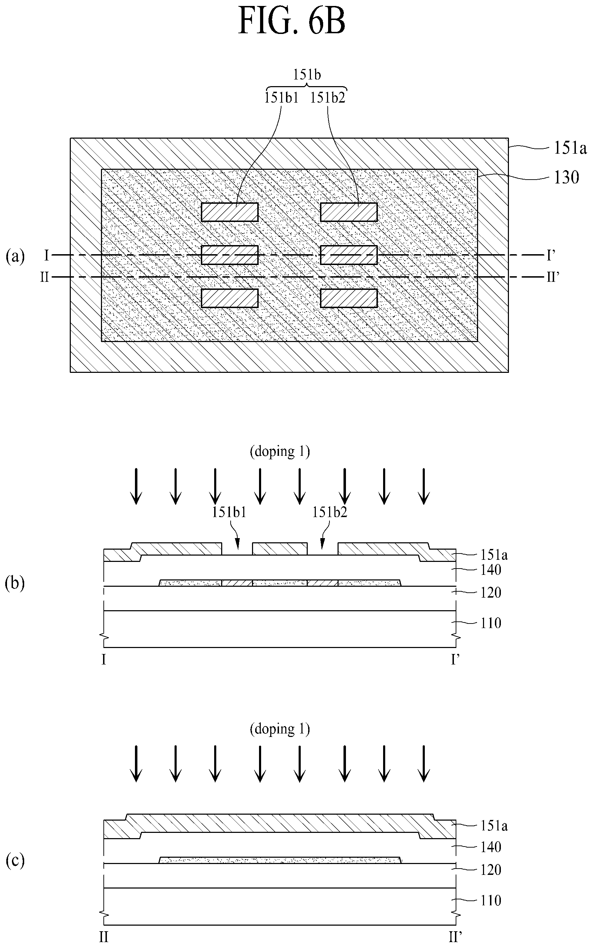

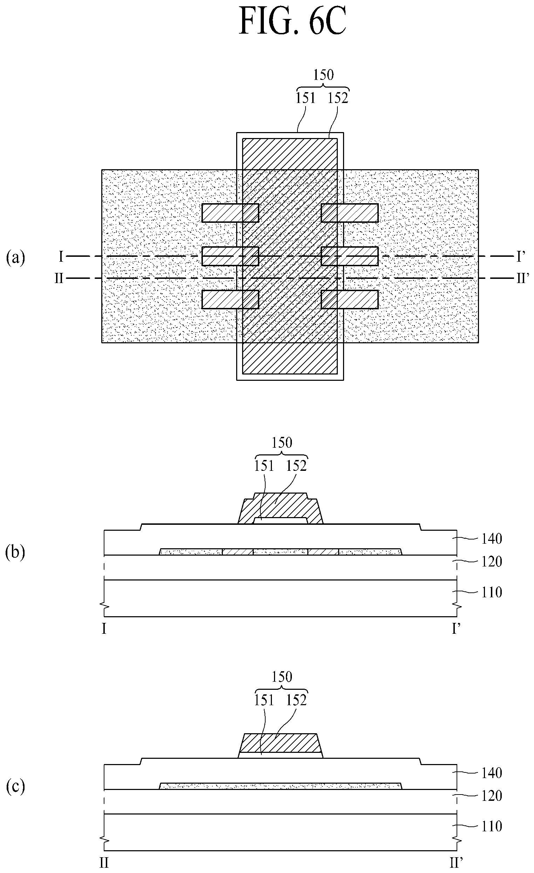

The first gate electrode 151 and the second gate electrode 152 may be formed of the same material or different materials. As shown in FIGS. 6B and 6C, the first gate electrode 151 and the second gate electrode 152 are formed at a different manufacturing stage. Accordingly, even though in some embodiments, the first gate electrode 151 and the second gate electrode 152 can be made of the same material, because the first gate electrode 151 and the second gate electrode 152 are formed at a different stage, the boundary between the first gate electrode 151 and the second gate electrode 152 may be distinct and visible as shown in FIG. 4.

Also, according to an embodiment of the present disclosure, at least a portion of the second gate electrode 152 may cover at least a portion of a side surface of the first gate electrode 151. Specifically, a configuration in which the second gate electrode 152 covers a side surface of the first gate electrode 151 is illustrated in FIG. 2. In particular, the first gate electrode 151 as seen from the cross-sectional view of FIG. 2 has a first side surface LSS, a second side surface RSS opposite to and facing the first side surface LSS, and an upper surface USS between the first side surface LSS and the second side surface RSS. In some embodiments, the second gate electrode 152 covers the first side surface LSS, the second side surface RSS, and the upper surface USS of the first gate electrode 151. In some embodiments, the second gate electrode 152 covers and directly contacts the first side surface LSS, the second side surface RSS, and the upper surface USS of the first gate electrode 151.

Referring to FIGS. 2 and 3, an interlayer insulating layer 160 may be disposed on the gate electrode 150. The interlayer insulating layer 160 may be made of an organic or inorganic insulating material. The interlayer insulating layer 160 may be formed of a composite layer of an organic layer and an inorganic layer.

According to an embodiment of the present disclosure, the thin film transistor 100 may include a source electrode 171 and a drain electrode 172 disposed on the interlayer insulating layer 160. Positions of the source electrode 171 and the drain electrode 172 may be exchanged with each other. However, an embodiment of the present disclosure is not limited thereto, and the source area 130a and the drain area 130b may serve as source and drain electrodes, respectively.

Referring to FIGS. 1 and 2, each of the source electrode 171 and the drain electrode 172 may be connected to the active layer 130 through a contact hole. Specifically, the source electrode 171 may be in contact with the source area 130a through a contact hole. The drain electrode 172 may be spaced apart from the source electrode 171 to be in contact with the drain area 130b through a contact hole.

According to an embodiment of the present disclosure, the source electrode 171 and the drain electrode 172 may be disposed on the same layer as the gate electrode 150. In this case, the source electrode 171 and the drain electrode 172 may be formed of the same material by the same process as the gate electrode 150.

In FIG. 4, a configuration in which the source electrode 171 and the drain electrode 172 are disposed on the same layer using the same material as the gate electrode 150 is illustrated. However, an embodiment of the present disclosure is not limited thereto, and the source electrode 171 and the drain electrode 172 may be disposed on a different layer from the gate electrode 150.

The thin film transistor 100 according to an embodiment of the present disclosure further includes an interlayer insulating layer 160 on the gate electrode 150, and the source electrode 171 and the drain electrode 172 may be disposed on the interlayer insulating layer 160. In this case, the gate electrode 150, the source electrode 171, and the drain electrode 172 may be formed of different materials, and are formed by different processes.

According to an embodiment of the present disclosure, each of the source electrode 171 and the drain electrode 172 may include at least one of molybdenum (Mo), aluminum (Al), chromium (Cr), gold (Au), titanium (Ti), nickel (Ni), neodymium (Nd), copper (Cu), and alloys thereof. Each of the source electrode 171 and the drain electrode 172 may be formed of a single layer made of a metal or an alloy of metals, or may be formed of two or more layers.

Specifically, referring to FIG. 4, the source electrode 171 may include a first source electrode 171a and a second source electrode 171b on the first source electrode 171a, and the drain electrode 172 may include a first drain electrode 172a and a second drain electrode 172b on the first drain electrode 172a.

In this case, the first source electrode 171a and the first drain electrode 172a may be disposed on the same layer using the same material as the first gate electrode 151, and the second source electrode 171b and the second drain electrode 172b may be disposed on the same layer using the same material as the second gate electrode 152.

In some embodiments, the first source electrode 171a may have a U-shaped cross-section that extends towards the second source area 130a2 and directly contacts the second source area 130a2. As shown in FIG. 4, both ends of the first source electrode 171a may contact the upper surfaces of the gate insulating layer 140. A center of the first source electrode 171a may be disposed in the contact hole and/or may contact the source area 130a, in particular the second source area 130a2. The second source electrode 171b that is disposed on top of the first source electrode 171a includes a trapezoidal cross-section. The second source electrode 171b further extends downwards to the second source area 130a2 to fill the U-shaped dip of the first source electrode 171a. The second source electrode 171b has a width that is less than a width of the first source electrode 171a such that when seen from a plan view, the first source electrode 171a fully overlaps the second source electrode 171b.

Similarly, the first drain electrode 172a may have a U-shaped cross-section that extends towards the second drain area 130b2 and directly contacts the second drain area 130b2. As shown in FIG. 4, both ends of the first drain electrode 172a may contact the upper surfaces of the gate insulating layer 140. A center of the first drain electrode 172a may be disposed in the contact hole and/or may contact the drain area 130b, in particular the second drain area 130b2. The second drain electrode 172b that is disposed on top of the first drain electrode 172a includes a trapezoidal cross-section. The second drain electrode 172b further extends downwards to the second drain area 130b2 to fill the U-shaped dip of the first drain electrode 172a. The second drain electrode 172b has a width that is less than a width of the first drain electrode 172a such that when seen from a plan view, the first drain electrode 172a fully overlaps the second drain electrode 172b.

Although not shown in the drawings, a light blocking layer may be disposed on the base substrate 110. In detail, the light blocking layer may be disposed between the base substrate 110 and the active layer 130. The light blocking layer may overlap the channel area 130n. The light blocking layer protects the channel area 130n by blocking light incident from the outside.

The light blocking layer may include at least one of an aluminum-based metal such as aluminum (Al) or an aluminum alloy, a molybdenum-based metal such as molybdenum (Mo) or a molybdenum alloy, chromium (Cr), tantalum (Ta), neodymium (Nd), titanium (Ti), and iron (Fe). According to an embodiment of the present disclosure, the light blocking layer may have electrical conductivity.

The light blocking layer may be omitted. Although not shown in FIGS. 1, 2, and 3, a buffer layer may be additionally disposed between the base substrate 110 and the light blocking layer. The light blocking layer may be electrically connected to one of the source electrode 171 and the drain electrode 172.

FIG. 5 is a diagram for describing a nitrogen (N) doping process, which is an example of the first dopant element of the present disclosure.

Specifically, referring to step (a) of FIG. 5, the active layer 130 made of an oxide semiconductor material includes hydrogen (H) flowed from an insulating layer and the like. More specifically, a high concentration of hydrogen (H) is included in a region of the channel area 130n adjacent to the source area 130a and the drain area 130b, and oxygen defects Vo are present.

In this case, when a region of the channel area 130n adjacent to the source area 130a and the drain area 130b is doped by nitrogen (N), the nitrogen (N) may be disposed at an oxygen defect (Vo) position to fill the oxygen defect (Vo) position, and may be stably disposed between metals.

In this case, referring to step (b) of FIG. 5, when hydrogen (H) flow into the channel area 130n doped with nitrogen (N), the hydrogen (H) flowed into the channel area 130n is combined with the nitrogen (N) disposed at the position of the oxygen vacancy (Vo). Accordingly, hydrogen (H) is ionized in a region of the channel area 130n adjacent to the source area 130a and the drain area 130b, and thus an increase in the concentration of the carrier may be suppressed and prevented.

As a result, even if the channel area 130n has a large width (W), the depth of conductorization penetration can be controlled, and the threshold voltage (Vth) of the thin film transistor 100 can be suppressed and prevented from moving in the negative (-) direction.

Hereinafter, a method of manufacturing the thin film transistor 100 according to an embodiment of the present disclosure will be described.

According to one embodiment of the present disclosure, the method of manufacturing the thin film transistor 100 includes the step of forming the active layer 130 and the gate insulating layer 140 in order, the step of first doping the active layer 130, the step of forming the gate electrode 150 at least partially overlapping the active layer 130 on the active layer 130, and the step of second doping the active layer 130.

Specifically, the step of first doping the active layer 130 includes a step of forming the first gate electrode material layer 151a on the active layer 130 and a step of doping the active layer 130 with the first dopant element using the first gate electrode material layer 151a as a mask.

The step of forming the gate electrode 150 includes a step of forming a second gate electrode material layer (not shown) on the first gate electrode material layer 151a, and a step of concurrently (or in some cases, simultaneously) etching the first gate electrode material layer 151a and the second gate electrode material layer (not shown).

In addition, the step of second doping the active layer 130 includes a step of doping the active layer 130 with a second dopant element using the gate electrode 150 as a mask.

In this case, the gate electrode 150 may include a first gate electrode 151 and a second gate electrode 152 on the first gate electrode 151.

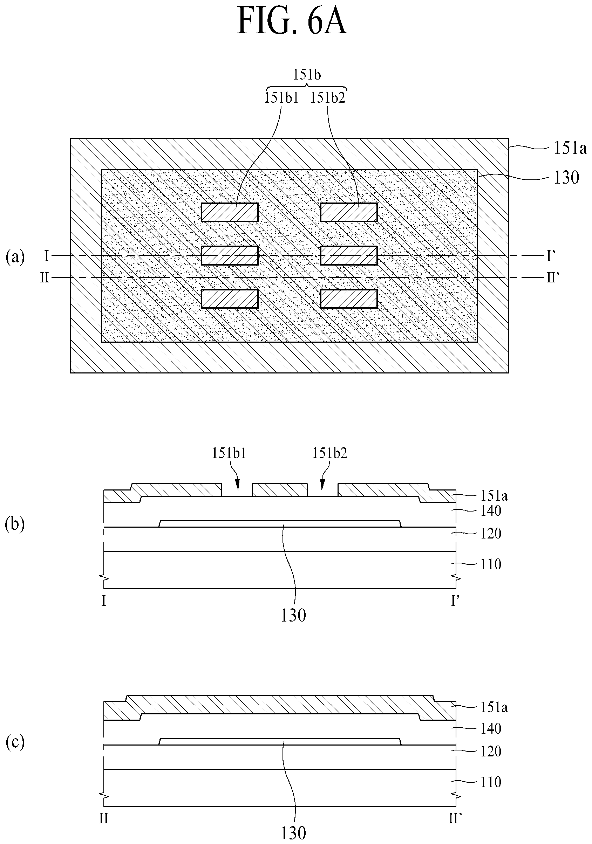

FIGS. 6A to 6E are process diagrams of a method of manufacturing a thin film transistor 100 according to an embodiment of the present disclosure. In each of FIGS. 6A to 6E, (a) corresponds to a plan view in the process of the manufacturing method, (b) corresponds to a cross-sectional view taken along line I-I' of the figure (a), and (c) corresponds to a cross-sectional view taken along line II-II' of the figure (a).

Referring to FIG. 6A, a buffer layer 120, an active layer 130, and a gate insulating layer 140 are formed on the base substrate 110, and a first gate electrode material layer 151a is formed on the gate insulating layer 140.

The first gate electrode material layer 151a includes a hole 151b exposing the gate insulating layer 140. In this case, the hole 151b exposing the gate insulating layer 140 means a region in which the first gate electrode material layer 151a is patterned within the region of the first gate electrode material layer 151a.

Specifically, the hole 151b of the first gate electrode material layer 151a includes a plurality of sub-holes 151b1 and 151b2, and each of the plurality of sub-holes 151b1 and 151b2 is spaced apart from each other.

More specifically, a region defined by the hole 151b, in particular the sub-holes 151b1, 151b2, of the first gate electrode material layer 151a overlaps the active layer 130.

Referring to FIG. 6B, the active layer 130 may be doped with a first dopant element using the first gate electrode material layer 151a as a mask (first doping, doping 1).

Specifically, a region of the active layer 130 overlapping a region defined by the hole 151b of the first gate electrode material layer 151a may be doped by the first dopant element.

Referring to FIG. 6C, a gate electrode 150 at least partially overlapping the active layer 130 may be formed on the active layer 130.

Specifically, although not shown in the drawings, after the second gate electrode material layer (not shown) is formed on the first gate electrode material layer 151a, the first gate electrode material layer 151a and the second gate electrode material layer may be concurrently (or in some cases, simultaneously) etched to form the gate electrode 150.

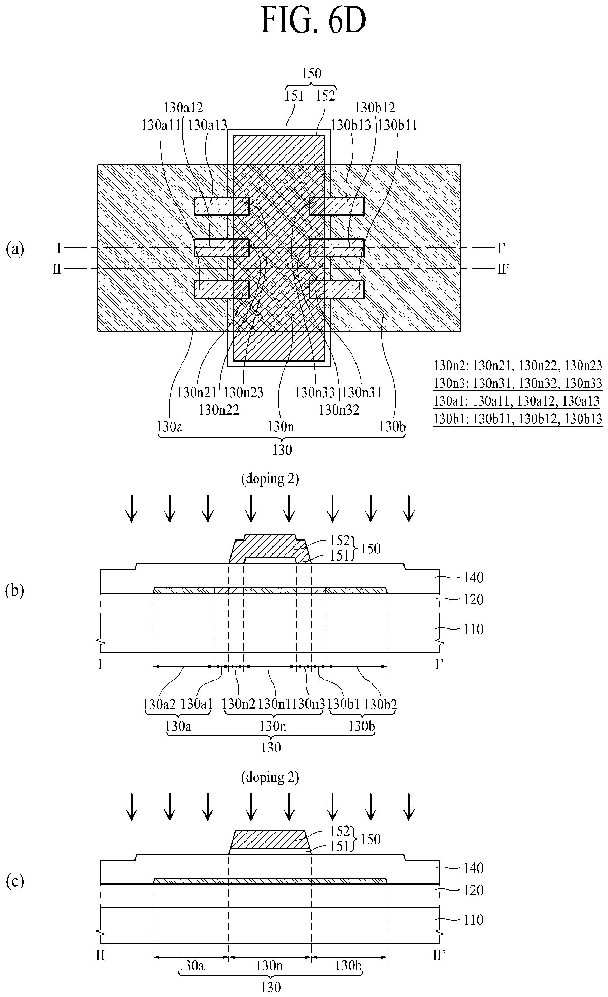

Referring to FIG. 6D, the active layer 130 may be doped with a second dopant element using the gate electrode 150 as a mask (second doping, doping 2).

The second dopant element may include at least one of boron (B), phosphorus (P), fluorine (F), and hydrogen (H).

The active layer 130 is divided into a channel area 130n, a source area 130a, and a drain area 130b by a process of doping the active layer 130 with the first dopant element and doping the active layer 130 with the second dopant element. Specifically, the channel area 130n is divided into a first channel area 130n1, a second channel area 130n2, and a third channel area 130n3. The source area 130a is divided into a first source area 130a1 and a second source area 130a2, and the drain area 130b may be divided into a first drain area 130b1 and a second drain area 130b2.

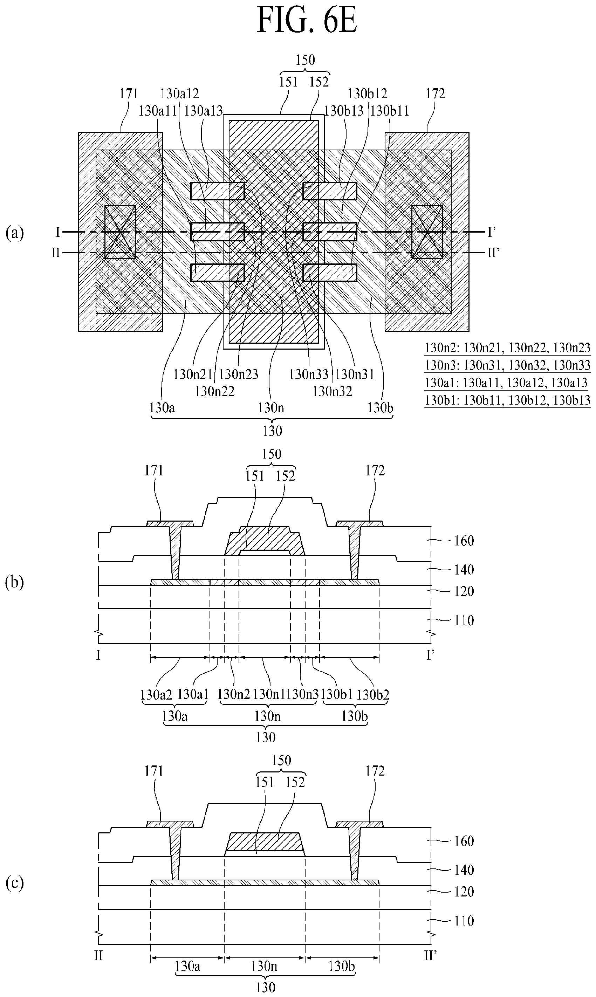

Referring to FIG. 6E, an interlayer insulating layer 160, a source electrode 171, and a drain electrode 172 are formed on the gate electrode 150.

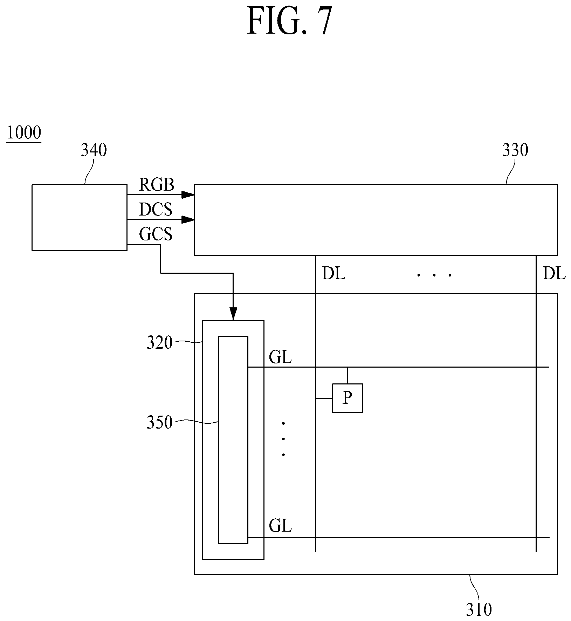

FIG. 7 is a schematic diagram illustrating a display apparatus 1000 according to further still another embodiment of the present disclosure.

As shown in FIG. 7, the display apparatus 1000 according to further still another embodiment of the present disclosure may include a display panel 310, a gate driver 320, a data driver 330 and a controller 340.

The display panel 310 includes gate lines GL and data lines DL, and pixels Pare disposed in intersection areas of the gate lines GL and the data lines DL. An image is displayed by driving of the pixels P. The gate lines GL, the data lines DL and the pixels P may be disposed on the base substrate 110.

The controller 340 controls the gate driver 320 and the data driver 330.

The controller 340 outputs a gate control signal GCS for controlling the gate driver 320 and a data control signal DCS for controlling the data driver 330 by using a signal supplied from an external system not shown. Also, the controller 340 samples input image data input from the external system, realigns the sampled data and supplies the realigned digital image data RGB to the data driver 330.

The gate control signal GCS includes a gate start pulse GSP, a gate shift clock GSC, a gate output enable signal GOE, a start signal Vst and a gate clock GCLK. Also, control signals for controlling a shift register may be included in the gate control signal GCS.

The data control signal DCS includes a source start pulse SSP, a source shift clock signal SSC, a source output enable signal SOE and a polarity control signal POL.

The data driver 330 supplies a data voltage to the data lines DL of the display panel 310. In detail, the data driver 330 converts the image data RGB input from the controller 340 into an analog data voltage and supplies the data voltage to the data lines DL.

According to one embodiment of the present disclosure, the gate driver 320 may be packaged on the display panel 310. In this way, a structure in which the gate driver 320 is directly packaged on the display panel 310 will be referred to as a Gate In Panel (GIP) structure. In detail, in the Gate In Panel (GIP) structure, the gate driver 320 may be disposed on the base substrate 110.

The display apparatus 1000 according to one embodiment of the present disclosure may include the above-described thin film transistors 100, and 200. The display apparatus 1000 may include at least one or more of at least one of the thin film transistors 100 and 200. According to one embodiment of the present disclosure, the gate driver 320 may include the above-described thin film transistors 100, and 200. While FIG. 7 shows a display apparatus, the above-described thin film transistors 100 and 200 can be incorporated in an electronic device (e.g., smartphones, tablets, computers, televisions, wearable devices, medical devices, or the like) as well.

The gate driver 320 may include a shift register 350.

The shift register 350 sequentially supplies gate pulses to the gate lines GL for one frame by using the start signal and the gate clock, which are transmitted from the controller 340. In this case, one frame means a time period at which one image is output through the display panel 310. The gate pulse has a turn-on voltage capable of turning on a switching device (thin film transistor) disposed in the pixel P.

Also, the shift register 350 supplies a gate-off signal capable of turning off the switching device, to the gate line GL for the other period of one frame, at which the gate pulse is not supplied. Hereinafter, the gate pulse and the gate-off signal will be collectively referred to as a scan signal SS or Scan.

The shift register 350 may include the above-described thin film transistors 100, and 200.

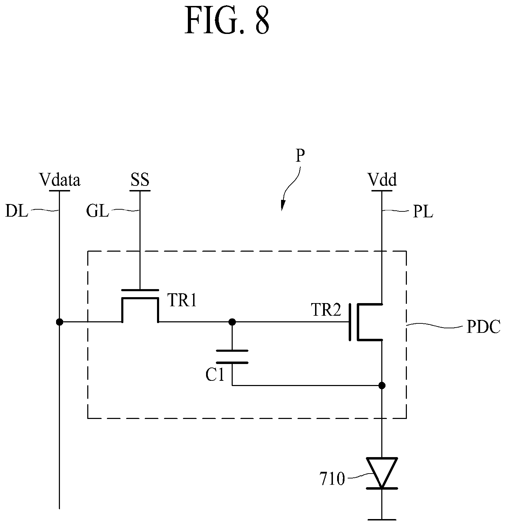

Referring to FIG. 7, the display panel 310 includes a plurality of pixels P and these pixels may include subpixels. Each pixel P or subpixel may include a light emitting element such as a light emitting diode or an organic light emitting diode (OLED). The light emitting element may also be referred to as a display element 710. In addition, each pixel P may include a thin film transistor TFT coupled to the light emitting element 710. The thin film transistor coupled to the light emitting element 710 may be the second thin film transistor TR2 as shown in FIG. 8.

FIG. 8 is a circuit view illustrating any one pixel P of FIG. 7.

The circuit view of FIG. 8 is an equivalent circuit view for the pixel P of the display apparatus 1000 that includes an organic light emitting diode (OLED) as a display element 710.

Referring to FIG. 8, the pixel P includes a display element 710 and a pixel driving circuit PDC for driving the display element 710. In detail, the display apparatus 1000 according to one embodiment of the present disclosure may include a pixel driving circuit PDC on the base substrate 110.

The pixel driving circuit PDC of FIG. 8 includes a first thin film transistor TR1 that is a switching transistor and a second thin film transistor TR2 that is a driving transistor. The display apparatus 1000 according to another embodiment of the present disclosure may include at least one of the above-described thin film transistors 100, and 200. The first thin film transistor TR1 and/or the second thin film transistor TR2 may be, or may be implemented as, one of the thin film transistors 100 and 200.

The first thin film transistor TR1 is connected to the gate line GL and the data line DL, and is turned on or off by the scan signal SS supplied through the gate line GL.

The data line DL provides a data voltage Vdata to the pixel driving circuit PDC, and the first thin film transistor TR1 controls applying of the data voltage Vdata.

The driving power line PL provides a driving voltage Vdd to the display element 710, and the first thin film transistor TR1 controls the driving voltage Vdd. The driving voltage Vdd is a pixel driving voltage for driving the organic light emitting diode (OLED) that is the display element 710.

When the first thin film transistor TR1 is turned on by the scan signal SS applied from the gate driver 320 through the gate line GL, the data voltage Vdata supplied through the data line DL is supplied to a gate electrode of the second thin film transistor TR2 connected to the display element 710. The data voltage Vdata is charged in a storage capacitor C1 formed between the gate electrode and a source electrode of the second thin film transistor TR2.

The amount of a current supplied to the organic light emitting diode (OLED), which is the display element 710, through the second thin film transistor TR2 is controlled in accordance with the data voltage Vdata, whereby a gray scale of light output from the display element 710 may be controlled.

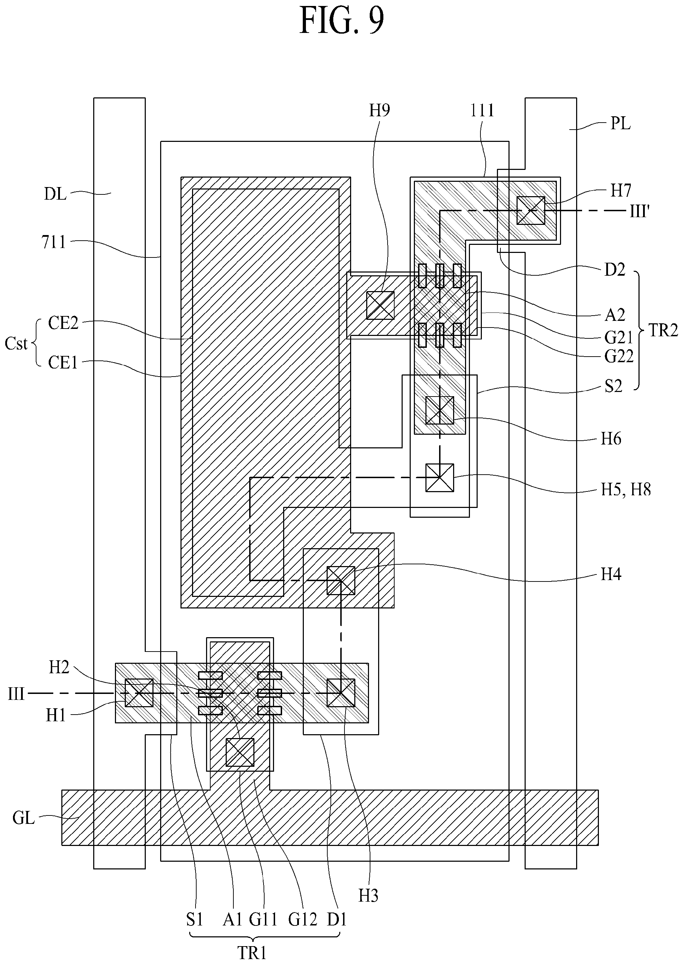

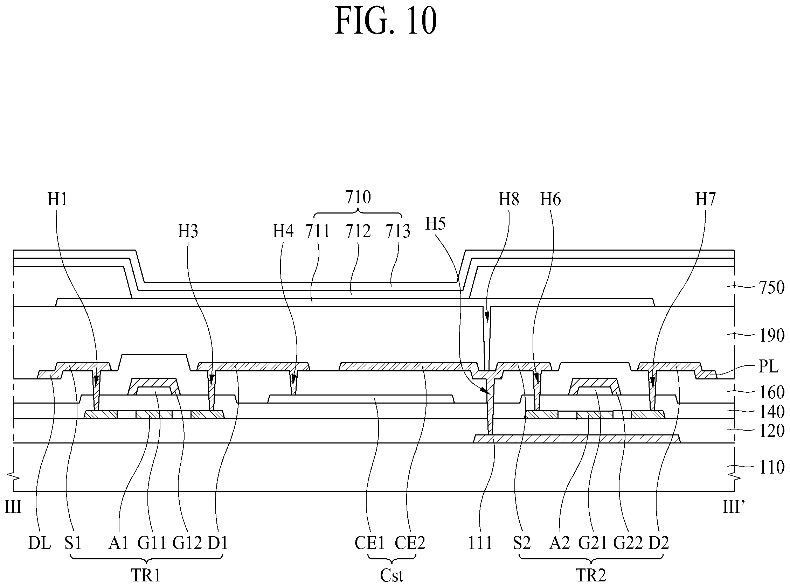

FIG. 9 is a plan view of the pixel of FIG. 8, and FIG. 10 is a cross-sectional view taken along line III-III' of FIG. 9.

Referring to FIGS. 9 and 10, the first thin film transistor TR1 and the second thin film transistor TR2 are disposed on the base substrate 110.

The base substrate 110 may be made of glass or plastic. As the base substrate 110, plastic having flexible characteristics, for example, polyimide (PI) may be used.

The light blocking layer 111 is disposed on the base substrate 110. The light blocking layer 111 may have light blocking characteristics. The light blocking layer 111 may protect the active layers A1 and A2 by blocking light incident from the outside.

The buffer layer 120 is disposed on the light blocking layer 111. The buffer layer 120 is made of an insulating material and protects the active layers A1 and A2 from moisture or oxygen introduced from the outside.

A first active layer A1 of the first thin film transistor TR1 and a second active layer A2 of the second thin film transistor TR2 are disposed on the buffer layer 120.

The first active layer A1 and the second active layer A2 may include, for example, an oxide semiconductor material. The first active layer A1 and the second active layer A2 may be formed of an oxide semiconductor layer made of an oxide semiconductor material.

In the first thin film transistor TR1, the first active layer A1 may include a channel area, a source area, and a drain area. The channel area of the first active layer A1 overlaps the gate electrodes G11 and G12. According to another embodiment of the present disclosure, the source area may be referred to as the source electrode S1, and the drain area may be referred to as the drain electrode D1.

In the second thin film transistor TR2, the second active layer A2 may include a channel area, a source area, and a drain area. The channel area of the second active layer A2 overlaps the gate electrodes G21 and G22. According to another embodiment of the present disclosure, the source area may be referred to as the source electrode S2, and the drain area may be referred to as the drain electrode D2.

A gate insulating layer 140 is disposed on the active layers A1 and A2. The gate insulating layer 140 covers upper surfaces of the active layers A1 and A2.

The gate electrodes G11 and G12 of the first thin film transistor TR1 and the gate electrodes G21 and G22 of the second thin film transistor TR2 are disposed on the gate insulating layer 140.

Specifically, the gate electrodes G11 and G12 of the first thin film transistor TR1 include a first gate electrode G11 and a second gate electrode G12 on the first gate electrode G11. Also, the gate electrodes G21 and G22 of the second thin film transistor TR2 include a first gate electrode G21 and a second gate electrode G22 on the first gate electrode G21.

Although not shown in the drawings, a gate line GL may be disposed on the gate insulating layer 140. The gate electrode G1 of the first thin film transistor TR1 may extend from the gate line GL or may be a part of the gate line GL.

Referring to FIGS. 9 and 10, a first capacitor electrode CE1 of a storage capacitor Cst is formed on the gate insulating layer 140. The first capacitor electrode CE1 may be formed by the same process as the second gate electrode G12 of the first thin film transistor TR1 and the second gate electrode G22 of the second thin film transistor TR2.

An interlayer insulating layer 160 is disposed on the gate electrodes G11, G12, G21, and G22 and the first capacitor electrode CE1.

The data line DL and the driving power line PL are disposed on the interlayer insulating layer 160. Also, the source electrode S1 and the drain electrode D1 of the first thin film transistor TR1 are disposed on the interlayer insulating layer 160, and the source electrode S2 and the drain electrode D2 of the second thin film transistor TR2 are disposed on the interlayer insulating layer 160.

The source electrode S1 of the first thin film transistor TR1 may be integrally formed with the data line DL and may have a structure extending from the data line DL.

The source electrode S1 of the first thin film transistor TR1 may be in contact the active layer A1 of the first thin film transistor TR1 through the first contact hole H1.

The source electrode S1 of the first thin film transistor TR1 may be in contact with a side surface of the active layer A1 of the first thin film transistor TR1 through the first contact hole H1.

The first gate electrode G11 and the second gate electrode G12 of the first thin film transistor TR1 are connected through a second contact hole H2.

The drain electrode D1 of the first thin film transistor TR1 is in contact with the active layer A1 of the first thin film transistor TR1 through the third contact hole H3. The drain electrode D1 of the first thin film transistor TR1 is in contact with the other side surface of the active layer A1 of the first thin film transistor TR1 through the third contact hole H3. Also, the drain electrode D1 of the first thin film transistor TR1 is connected to the first capacitor electrode CE1 through the fourth contact hole H4. As a result, the first capacitor electrode CE1 may be connected to the first thin film transistor TR1.

The drain electrode D2 of the second thin film transistor TR1 may be integrally formed with the driving power line PL, and may have a structure extending from the driving power line PL.

The drain electrode D2 of the second thin film transistor TR2 may be in contact with the active layer A2 of the second thin film transistor TR2 through the seventh contact hole H7.

The drain electrode D2 of the second thin film transistor TR2 may be in contact with a side surface of the active layer A2 of the second thin film transistor TR2 through the seventh contact hole H7.

The source electrode S2 of the second thin film transistor TR2 is in contact with the active layer A2 of the second thin film transistor TR2 through the sixth contact hole H6. The source electrode S2 of the second thin film transistor TR2 is in contact with the other side surface of the active layer A2 of the second thin film transistor TR2 through the sixth contact hole H6. Also, the source electrode S2 of the second thin film transistor TR2 is connected to the light blocking layer 111 through the fifth contact hole H5. The same voltage as the source electrode S2 of the second thin film transistor TR2 may be applied to the light blocking layer 111 overlapping the second thin film transistor TR2.

The source electrode S2 of the second thin film transistor TR2 may extend onto the interlayer insulating layer 160 to form the second capacitor electrode CE2 of the storage capacitor Cst.

According to an embodiment of the present disclosure, the first capacitor electrode CE1 and the second capacitor electrode CE2 may overlap to form the storage capacitor Cst.

Referring to FIGS. 9 and 10, a planarization layer 190 is disposed on the data line DL, the driving power line PL, the source electrodes S1 and S2, the drain electrodes D1 and D2, and the second capacitor electrode CE2. The planarization layer 190 planarizes upper portions of the first thin film transistor TR1 and the second thin film transistor TR2 and protects the first thin film transistor TR1 and the second thin film transistor TR2. The planarization layer 190 serves as a protection layer.

A first electrode 711 of the display element 710 is disposed on the planarization layer 190. The first electrode 711 of the display element 710 is in contact with the second capacitor electrode CE2 through the eighth contact hole H8 formed in the planarization layer 190. As a result, the first electrode 711 of the display element 710 may be connected to the source electrode S2 of the second thin film transistor TR2.

The bank layer 750 is disposed at an edge of the first electrode 711. The bank layer 750 defines a light emitting area of the display element 710.

The organic light emitting layer 712 is disposed on the first electrode 711, and the second electrode 713 is disposed on the organic light emitting layer 712. Accordingly, the display element 710 is completed. The display element 710 shown in FIG. 8 is an organic light emitting diode (OLED). Therefore, the display device 1000 according to an embodiment of the present disclosure is an organic light emitting display device.

The pixel driving circuit PDC according to another configuration of the present disclosure may be formed in various structures other than the structure described above. The pixel driving circuit PDC may include, for example, three or more thin film transistors.

According to the present disclosure, the following advantageous effects may be obtained.

The thin film transistor according to embodiments of the present disclosure includes a channel area doped with the first dopant element, and thus may control the conductorization penetration depth even if the channel area has a large width.

In the thin film transistor according to embodiments of the present disclosure, the active layer includes a channel area doped with the first dopant element, and even if the channel area has a large width, the threshold voltage Vth may be prevented or suppressed from being shifted in the negative (-) direction.

It will be apparent to those skilled in the art that the present disclosure described above is not limited by the above-described embodiments and the accompanying drawings and that various substitutions, modifications and variations can be made in the present disclosure without departing from the scope of the present disclosure. Consequently, the scope of the present disclosure is defined by the accompanying claims.

## Claims

1. A thin film transistor (100, 200) including:
an active layer (130); and
a gate electrode (150) spaced apart from the active layer (130) and overlapping at least partially with the active layer (130);
wherein the active layer (130) includes:
a channel area (130n) that partially overlaps with the gate electrode (150);
a source area (130a) coupled to one side of the channel area (130n); and
a drain area (130b) coupled to the other side of the channel area (130n);
wherein the channel area (130n) includes:
a first channel area (130n1) that overlaps with the gate electrode (150);
a second channel area (130n2) coupled to the source area (130a) and doped by a first dopant element; and
a third channel area (130n3) coupled to the drain area (130b) and doped by the first dopant element;
wherein the second channel area (130n2) and the third channel area (130n3) are spaced apart from each other.

2. The thin film transistor of claim 1, the gate electrode (150) includes:
a first gate electrode (151); and
a second gate electrode (152) on the first gate electrode (151);
wherein the first gate electrode (151) and the second gate electrode (152) contact each other; and
wherein at least a portion of the second gate electrode (152) does not overlap with the first gate electrode (151).

3. The thin film transistor of claim 2, wherein the first channel area (130n1) overlaps with the first gate electrode (151) and the second gate electrode (152), and
wherein the second channel area (130n2) and the third channel area (130n3) each overlap the second gate electrode (152), wherein preferably at least a portion of the second channel area (130n2) and the third channel area (130n3) overlap the first gate electrode (151).

4. The thin film transistor of any one of the preceding claims, wherein the first dopant element includes at least one of nitrogen (N), sulfur (S), chlorine (Cl), gallium (Ga), tungsten (W), iron (Fe), and tin (Sn).

5. The thin film transistor of any one of the preceding claims, each of the second channel area (130n2) and the third channel area (103n3) include a first dopant element having a concentration of 4 to 15 atomic% based on the number of atoms, and/or
wherein each of the second channel area (130n2) and the third channel area (130n3) have a carrier concentration lower than that of the first channel area (130n1).

6. The thin film transistor of any one of the preceding claims, wherein the source area (130a) includes:
a first source area (130a1) coupled to the second channel area (130n2) and doped by the first dopant element; and
a second source area (130a2) doped by a second dopant element; and
wherein the drain area (130b) includes:
a first drain area (130b1) coupled to the third channel area (130n3) and doped by the first dopant element; and
a second drain area (130b2) doped by the second dopant element; and
wherein the second dopant element includes at least one of boron (B), phosphorus (P), fluorine (F), and hydrogen (H).

7. The thin film transistor of any one of the preceding claims, wherein the second channel area (130n2) includes a plurality of second sub-channel areas, and the third channel area (130n3) includes a plurality of third sub-channel areas,
wherein the second sub-channel areas are spaced apart from each other, and
wherein the sub-channel areas are spaced apart from each other.

8. The thin film transistor of claim 6 or 7, wherein the first source area (130a1) includes a plurality of first sub-source areas, and the first drain area (130b1) includes a plurality of first sub-drain areas,
wherein the first sub-source areas are spaced apart from each other, and
wherein the first sub-drain areas are spaced apart from each other.

9. The thin film transistor of any one of the preceding claims, further including a source electrode (171) and a drain electrode (172) coupled to the active layer.

10. The thin film transistor of claim 9, further including an interlayer insulating layer (160) disposed on the gate electrode (150), and
the source electrode (171) and the drain electrode (172) are disposed on the interlayer insulating layer (160).

11. The thin film transistor of claim 9 or 10, wherein the source electrode (171) includes:
a first source electrode (171a); and
a second source electrode (171b) on the first source electrode (171a);
wherein the drain electrode (172) includes:
a first drain electrode (172a); and
a second drain electrode (172b) on the first drain electrode (172a);
wherein the first source electrode (171a) and the first drain electrode (172a) are disposed on the same layer using the same material as the first gate electrode (151), and
wherein the second source electrode (171b) and the second drain electrode (172b) are disposed on the same layer using the same material as the second gate electrode (152).

12. The thin film transistor of any one of the preceding claims, wherein a resistance of the second channel area (130n2) and a resistance of the third channel area (130n3) are higher than a resistance of the first channel area (130n1), and/or wherein a resistance of the second channel area (130n2) and a resistance of the third channel area (130n3) are higher than that of a region of the active layer other than the second channel area (130n2) and the third channel area (130n2).

13. A manufacturing method of the thin film transistor, comprising:
forming an active layer (130) and a gate insulating layer (140) sequentially;
first doping the active layer (130);
forming a gate electrode (150) that at least partially overlaps the active layer (130) on the active layer (130); and
second doping the active layer,
wherein the first doping the active layer (130) includes:
forming a first gate electrode material layer (151a) on the active layer (130); and
doping the active layer with a first dopant element using the first gate electrode material layer as a mask,
wherein the forming the gate electrode (150) includes:
forming a second gate electrode material layer on the first gate electrode material layer (151a);
and
etching the first gate electrode material layer (151a) and the second gate electrode material layer concurrently,
wherein the second doping the active layer includes:
doping the active layer (130) with a second dopant element using the gate electrode (150) as a mask,
wherein the gate electrode includes a first gate electrode (151) and a second gate electrode (152) on the first gate electrode (151), and
the first gate electrode material layer (151a) includes at least one hole (151 b1, 151 b2) exposing the gate insulating layer.

14. The manufacturing method of the thin film transistor of claim 13, wherein the second dopant element includes at least one of boron (B), phosphorus (P), fluorine (F), and hydrogen (H).

15. A display apparatus comprising at least one thin film transistor of any one of claims 1 to 12.
